# EUROPEAN PATENT SPECIFICATION

(11) **EP 3 841 663 B1**
(45) Date of publication and mention of the grant of the patent: **19.07.2023**
(21) Application number: 19766116.8
(22) Date of filing: 12.08.2019
(51) Int. Cl.: H02S 20/00

(54) **A SOLAR POWER PLANT AND METHOD OF INSTALLING A SOLAR POWER PLANT**
SOLARANLAGE UND VERFAHREN ZUR INSTALLATION EINER SOLARANLAGE
CENTRALE SOLAIRE ET SON PROCÉDÉ D'INSTALLATION

(30) Priority: 24.08.2018 GB 201813842
(43) Date of publication of application: 30.06.2021
(60) Divisional application: 21168979.9
(73) Proprietor: Ocean Sun AS, 1360 Fornebu (NO)
(72) Inventor: BJØRNEKLETT, Børge, 1359 Eiksmarka (NO)
(74) Representative: Zacco Norway AS
(86) International application number: PCT/NO2019/050164
(87) International publication number: WO 2020/040643

(56) References cited:
- WO-A1-2011/076307
- WO-A1-2018/022655
- US-A1- 2016 329 858

## Description

The present invention relates to renewable energy production, and more specifically to apparatus and methods relating to floating solar power plants including a plurality of photovoltaic modules mounted on a flexible web or membrane.

### BACKGROUND

Floating photovoltaic (PV) solar power systems are known, although not extensively used at present. Such systems are typically deployed on calm water, i.e. on lakes, hydroelectric power dams, water reservoirs, rivers, or the like. Some of the challenges associated with floating solar power systems include exposure to loads from waves and currents, challenging and labour-intensive deployment of the plant (or components thereof), and problems associated with access for system maintenance and cleaning (e.g. salt or solid particles accumulating on plant surfaces). Currently available floating solar power systems are also limited by their relatively high cost.

Examples of prior art which may be useful for understanding the background include: US 2012/0242275 A1, which describes a large-scale ocean mobile solar power generation system; US 2015/0162866 A1, which describes a supporting device for a solar panel; US 2014/0224165 A1, which describes a device for supporting a photovoltaic panel; KR 1011013316 B and KR 101612832 B, which describe solar cells arranged on floating devices; and WO2017/209625, which discloses a solar power plant comprising a plurality of stiff PV modules on a flexible membrane which is, in use, floated on the surface of a body of water. WO2018/022655 discloses a floating solar power generation system in which a plurality of PV modules are mechanically bound together to form a contiguous array which floats on or in a body of water. Each module comprises a plurality of solar cells encased within a laminated support structure.

At present there are both technical and economic challenges associated with floating PV power plants. There is consequently a need for improved systems and methods for such renewable power generation for a variety of applications and purposes. The present invention aims to provide improved apparatuses according to claim and methods according to claim 12 relating to floating solar power plants, providing advantages and/or remedying current challenges or disadvantages associated with known systems and techniques.SUMMARY

According to a first aspect we provide a solar power plant comprising a pliable mat having a plurality of photovoltaic (PV) modules fixed thereon, each module comprising a layer of photovoltaic cells sandwiched between an upper plate and a lower plate, and being secured to the mat such that the lower plate lies on or directly adjacent a top surface of the mat.

The lower plate may be a glass plate.

The lower plate may have a thickness between 0.5 mm and 4 mm, between 1 mm and 3 mm, or about 2.5 mm.

The upper plate may be transparent or translucent. The upper plate may be a glass plate or a polymer plate.

The upper plate may have a thickness between 0.5 mm and 4 mm, between 1 mm and 3 mm, or about 2.5 mm.

The upper and lower plates may have the same thickness.

The mat may have has a thickness of between 0.3 mm and 5 mm, between 0.5 mm and 1.5 mm, or about 1 mm.

At least one of the PV modules may be secured to the mat by means of an attachment assembly comprising two elongate module profiles secured to two generally parallel opposite edges of the PV module 1, and two corresponding elongate mat profiles attached to the mat.

The profiles may be configured such that the PV module is secured to the mat by bringing the profiles on the PV modules into contact with the corresponding profile on the mat, and sliding the profiles relative to one another in a direction generally parallel to the edge of the PV module to which the module profile is secured, until they reach a desired end position in which separation of the two profiles by the application of a force generally perpendicular to the edge of the PV module is substantially prevented.

A fastener may be provided, when engaged, the fastener preventing any further relative movement of the two profiles generally parallel to the edge of the PV module.

The module profiles may be adhesively bonded to the edges of the PV module.

The mat profiles may be welded or sewn to the mat.

The module profile may include an elongate retaining feature which extends generally parallel to the edge of the PV module to which it is attached.

The retaining feature may be connected to the PV module by means of an elongate frame part having two generally parallel legs connected by a base part.

The legs may be secured to the lower and upper glass plates by means of an adhesive.

The frame part may be integral with the retaining feature.

The module profile may extend along the entire edge of the PV module.

The mat profile may include an elongate retaining feature which is configured to mate with the retaining feature of the module profile and which is secured to the mat using a web. The web may ensure that the separation between the mat and the retaining feature is generally constant along substantially the entire length of the retaining feature.

One of the retaining features may have a male part which is inserted into a corresponding female part of the other retaining feature.

The male part may comprise an elongate tube or rod, whilst the female part comprises an elongate tube having a split which extends parallel to its longitudinal axis.

The mat may be fixed to a floatation element.

The floatation element may be an endless, elongated floatation element which surrounds the mat.

According to a second aspect we provide a method of installing a floating photovoltaic power plant according to the first aspect comprising the step of deploying the flexible mat onto a body of water so that the mat floats on or at the surface of the body of water.

The mat may be deployed such that the lower glass plate is in direct contact with the body of water.

The step of deploying the solar power plant may be carried out from a vessel.

The method may further comprise transporting the solar power plant folded and stacked onboard the vessel.

The step of deploying the solar power plant may be carried out from a land-based location.

According to a third aspect we provide a solar power plant comprising a pliable mat having a photovoltaic (PV) module fixed thereon by means of an attachment assembly which comprising at least one elongate module profile secured to an edge of the PV module, and a corresponding elongate mat profile attached to the mat.

The profiles may be configured such that the PV module is secured to the mat by bringing the module profile into contact with the corresponding mat profile, and sliding the profiles relative to one another in a direction generally parallel to the edge of the PV module to which the module profile is secured, until they reach a desired end position in which separation of the two profiles by the application of a force generally perpendicular to the edge of the PV module is substantially prevented.

The PV module may have any of the features or combination of features of the PV module in the solar power plant according to the first aspect.

The PV module may be provided with two module profiles secured to two generally parallel opposite edges of the PV module, and two corresponding generally parallel mat profiles.

A fastener may be provided, when engaged, the fastener preventing any further relative movement of the two profiles generally parallel to the edge of the PV module.

The module profiles may be adhesively bonded to the edges of the PV module.

The mat profiles may be welded or sewn to the mat.

The module profile may include an elongate retaining feature which extends generally parallel to the edge of the PV module 1 to which it is attached.

The retaining feature may be connected to the PV module by means of an elongate frame part having two generally parallel legs connected by a base part.

The PV module may comprise a layer of photovoltaic cells sandwiched between an upper plate, and a lower plate.

The legs may be secured to the lower and upper plates by means of an adhesive.

The frame part may be integral with the retaining feature.

The module profile may extend along the entire edge of the PV module.

The mat profile may include an elongate retaining feature which is configured to mate with the retaining feature of the module profile and which is secured to the mat using a web. The web may ensures that the separation between the mat and the retaining feature is generally constant along substantially the entire length of the retaining feature.

One of the retaining features may have a male part which is inserted into a corresponding female part of the other retaining feature.

The male part may comprise an elongate tube or rod, whilst the female part comprises an elongate tube having a split which extends parallel to its longitudinal axis.

The mat may be fixed to a floatation element.

The floatation element may be an endless, elongated floatation element which surrounds the mat.

According to a fourth aspect we provide a method of installing a floating photovoltaic power plant according to the third aspect comprising the steps of securing a PV module to the mat by bringing the module profile into contact with the corresponding mat profile, and sliding the profiles relative to one another in a direction generally parallel to the edge of the PV module to which the module profile is secured until they reach a desired end position in which separation of the two profiles by the application of a force generally perpendicular to the edge of the PV module is substantially prevented.

The method may comprise, after carrying out this method step, operating a fastener to prevent any further relative movement of the two profiles generally parallel to the edge of the PV module.

One of the module profile or the mat profile may have a retaining feature is a male part, the other profile having a retaining feature which is a female part, wherein the method comprises inserting the male part of one profile into an end of the female part of each corresponding profile before sliding the female part relative to the male part generally parallel to the edge of the PV module to which the module profile is secured, until the male part is at least substantially enclosed by the female part.

The PV module may be provided with two module profiles secured to generally parallel opposite edges of the PV module, and the mat may be provided with two corresponding generally parallel mat profiles, and the method may comprise securing a PV module to the mat by simultaneously, concurrently or sequentially, bringing both the module profiles into contact with their corresponding mat profile, and sliding the profiles relative to one another in a direction generally parallel to the edge of the PV module to which the module profile is secured until they reach a desired end position in which separation of the two profiles by the application of a force generally perpendicular to the edge of the PV module is substantially prevented.

The method may further comprise the step of deploying the mat onto a body of water before carrying out the step of securing the PV module to the mat.

The method may comprise the step of deploying the mat onto a body of water after the PV module has been secured to the mat.

The PV module may comprise a layer of photovoltaic cells sandwiched between an upper glass plate and a lower glass plate, and the method may further comprise deploying the power plant such that the lower glass plate is in direct contact with the body of water.

The step of deploying the solar power plant may be carried out from a vessel.

The method may further comprise transporting the solar power plant folded and stacked onboard the vessel.

The step of deploying the solar power plant may be carried out from a land-based location.

In any of the aspects, each module may be substantially stiff by means of the upper plate being a stiff plate, the lower plate being a stiff plate, or both the upper and lower plates being stiff plates. The modules may advantageously not be compliant to folding or bending.

In any of the aspects, the modules may be separate modules which are not interconnected, but fixed only to the mat. Each module may be spaced from other modules.

In any of the aspects, the modules may be arranged in an x-y pattern, with rows and columns of modules, each row and each column comprising a plurality of individual modules.

In any of the aspects, each module may comprise one or more junction boxes for electric distribution. The junction boxes may be positioned on a top surface of the respective module, on a side surface of the module, or on the elongate module profiles.

### BRIEF DESCRIPTION OF THE DRAWINGS

Illustrative embodiments will now be described with reference to the appended drawings, in which:
Fig. 1 shows a diagrammatic view of a solar power plant according to the first and third aspect of the invention floating in the sea,
Fig. 2 shows a schematic illustration of a transverse cross-section through a portion of photovoltaic (PV) module suitable for use in a solar power plant according to the first aspect of the invention,
Fig. 3 shows an exploded view of a PV module suitable for use in a solar power plant according to the first aspect of the invention,
Fig. 4 shows a cross section of an edge of the PV module illustrated in Figures 2 & 3 attached to a pliable mat using an attachment assembly,
Fig. 5 shows an alternative embodiment of attachment assembly,
Fig.6 shows a further alternative embodiment of attachment assembly,
Fig. 7 shows a plan view of a PV module suitable for use in a solar power plant according to the first and third aspect of the invention, and
Fig. 8 shows a schematic illustration of an offshore solar power plant according to the first and third aspect of the invention.
Figs 9 and 10 show embodiments of a module comprising more junction boxes.

### DETAILED DESCRIPTION

Many fixed or floating offshore units such as oil and gas production platforms, drilling or processing installations require considerable amounts of energy to operate. Other demanding installations include large fish farms, or populated islands that are located far from the grid. The energy demand for these sites is commonly supplied via diesel or gas turbine generators. Due to the high energy consumption originating from fossil fuel sources and the subsequent release of carbon dioxide, the activity has raised considerable debate among environmentalists and politicians. Additionally, the cost of energy is an important consideration by operators and owners of such installations.

According to embodiments described herein, there is provided a floating renewable power generation installation suitable for connection to a regular, land-based electricity grid through a cable, or for standalone, off-grid power generation. Embodiments may be employed in remote or near-shore offshore locations or on inland waters and can, for example, be designed to replace fossil fuel based generators or power plants and thereby reduce the CO₂ footprint of the electric power generation. For example, many densely populated areas, including many megacities, are located near shore. In such areas, the available area or useable rooftops for conventional renewables, such as wind power and solar, is very limited. According to embodiments described herein, significant contributions can be made to renewable power generation in such areas, at moderate cost and with high operational reliability.

Embodiments of the system are suitable for a variety of applications, and can, for example, be designed to replace or provide a substantial part of the energy demand during daytime in the spring, summer and autumn. For example, PV may work well in hybrid power systems where flexible fuel based generators easily can level out the typical irregularities that occur with the shifting output from solar energy systems due to clouds and the position of the sun. Alternatively, batteries may also be used for energy storage.

The invention comprises a solar power plant comprising a plurality of PV modules 1 installed onto a flexible membrane or web, hereinafter referred to as a mat 2, to form a PV array. The PV array is buoyant, and so can float on the surface of a body of water such as the sea, to form an offshore solar power plant. In order to achieve this, the mat 2 may be made at least partly of a buoyant material, and / or the PV array may further comprise floatation elements which are fixed to or incorporated into the mat 2. Various ways of achieved this buoyancy are described in WO2017/209625.

The substrate mat 2 is fully flexible, essentially follows the motion of the sea waves and generally display a so-called hydro-elastic behaviour. Chopped waves and sea spray is effectively prevented by the presence of the mat 2, which may cover large areas. A plurality of mats 2 may also be interconnected.

The mat 2 may or may not be perforated, have recesses, one-way valves, pumps or other arrangements to allow drainage of water accumulated on the uppermost surface of the mat (such as rain water). The mat 2 may alternatively be made of a net, i.e. have relatively large openings. If desirable, the buoyancy of the mat 2 can be designed to maintain a thin film of water on top of parts of or substantially the entire mat 2. This may be beneficial for cooling of the mat 2 itself and/or the PV modules 1.

In a preferred embodiment, the mat 2 has a thickness between 0.3 mm and 5 mm, more preferably between 0.5 mm and 1.5 mm, most preferably about 1 mm. Typical tolerances for these figures may be +/- 0.2 mm.

The mats 2 can be constructed from sheet, a net, woven textile, film or plate from e.g. polyethylene, polypropylene, polyurethane, EVA, synthetic rubber or copolymers which can be fabricated in large sections. Alternatively, the fabric may also be multi-layered and or partially inflated by pockets or elongate tunnels containing gas, water having low salinity, buoyant solids, oils, jellies, foam or other components. In one preferred embodiment, the mat 2 is a polymer coated textile membrane. Multiple polymers may be used, e.g. different polymers on each side of the mat 2, and/or layers of different polymers making up the polymer coating.

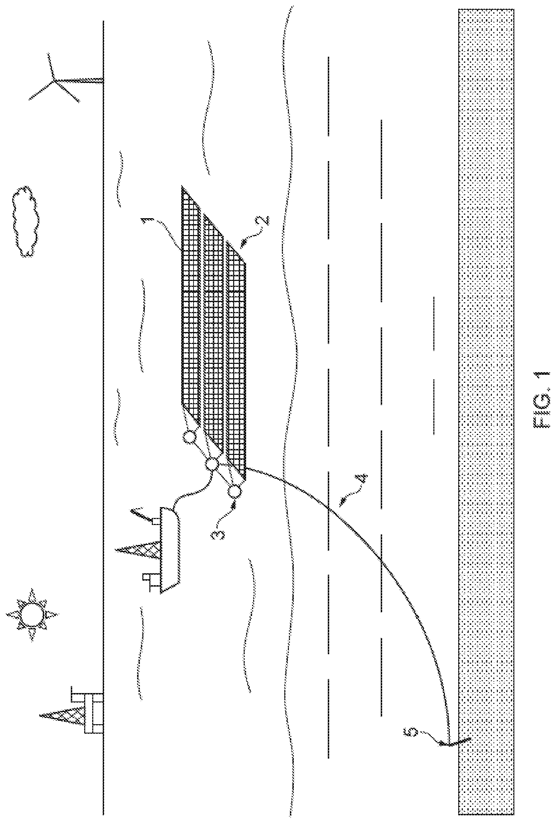

As mentioned above, the PV array can be designed with enough buoyancy to float, with the back side of the PV modules 1 partially submerged, enabling heat transfer with the water. The PV modules 1 may or may not be buoyant themselves. The module strings 2, or multiple strings forming an array, are moored to the seabed by anchors 5, chains and in combination with light weight rope 4 made of e.g. polyester or nylon. Alternative means of mooring is also possible, for example the module strings 2 can be fixed to land, e.g. in near-shore or dam applications. In the embodiment illustrated in Figure 1, buoys 3 are also installed to prevent the PV installation to be dragged under by sea current and/or wave drift forces. The geometry as well as the number and size of the anchors 5 and buoys 3 can be designed to minimise lateral drift forces. Adequate buoyancy and fixation points for anchoring can also be provided by one or several endless tubular elements encompassing the perimeter of the mat. The buoys 3 may also be equipped with appropriate lanterns to mark the location of the power plant for seafarers.

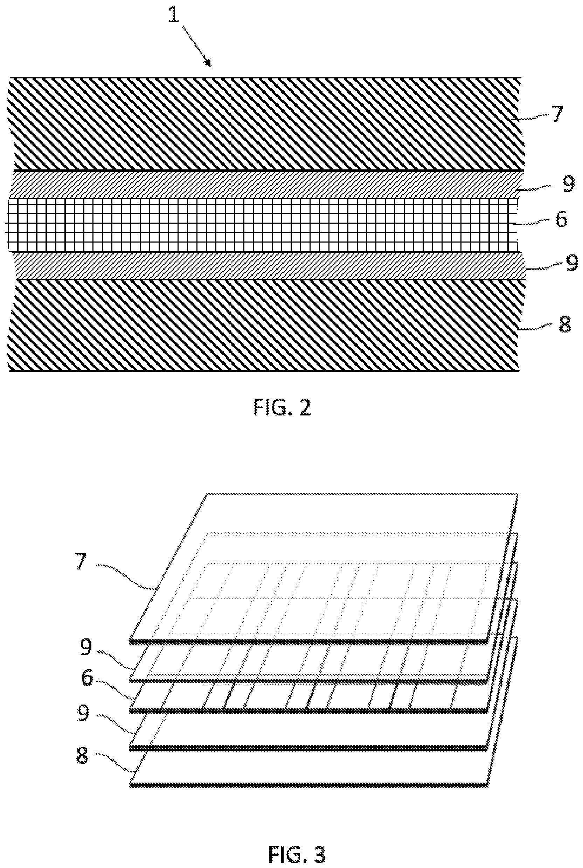

The PV modules 1 in this embodiment are dual glass modules comprising a layer of solar cells 6 sandwiched between an upper plate 7 and a lower glass plate 8, as illustrated in Figures 2 & 3.

The upper plate 7 preferably has a thickness between 0.5 mm and 4 mm, more preferably between 1 mm and 3 mm, and even more preferably about 2.5 mm. The upper plate may, alternatively, be made up of a transparent or translucent polymer, in one embodiment polycarbonate.

The lower plate 8 preferably has a thickness between 0.5 mm and 4 mm, more preferably between 1 mm and 3 mm, and even more preferably about 2.5 mm.

In one embodiment, the upper plate 7 and the lower plate 8 are both glass plates.

In one embodiment, the upper plate 7 and the lower plate 8 have the same thickness.

The inventor has discovered that a design with these configurations and thicknesses provide a particularly advantageous performance of the PV module when used offshore, while ensuring structural reliability and long lifetime.

The layer of solar cells 6 typically consist of multiple solar cells that are connected in series by metallic conductors soldered onto front and backside of the cells. For example, several strings of standard 6 x 6 inch solar cells may be arranged in an array of 6 x 10 or 6 x 12 cells and then interconnected.

In this example, the solar cells are laminated in between two layers of EVA (ethylene vinyl acetate) 9, the laminated solar cells between sandwiched between the upper and lower plates.

In order to protect the layer of solar cells from water ingress, a layer of sealant, typically EVA, is applied to the edges 1a around the entire perimeter of the PV module 1.

The PV modules 1 are interconnected electrically using high quality, non-degradable contacts capable of submersion. Each PV module 1 can be fitted with one or several smaller junction boxes (JB) for the plus and minus conductors as well as diodes separating individual strings of cells. Furthermore, the electrical cables can optionally be mechanically attached to the PV module 1 in order to strengthen the stress relief properties beyond what is offered by regular junction box terminals.

Depending on the size of the PV array, number of PV modules 1, designed peak wattage etc., the PV array is connected to inverters capable of transforming the power to the intended onshore or offshore consumer. If the inverters and transformers are not installed directly at an end user's offshore facility, they can be encapsulated and made buoyant. The latter is particularly relevant for large area installation with e.g. multiple string inverters and where the power is delivered through a main power cable to the end user.

Not accounting for the JBs, the size of the dual glass module is typically in the range: thickness from 4 to 8 mm, width between 0.9 and 1 m and length between 1.6 and 1.7 meters.

In order to operate at maximum efficiency, over-heating of PV modules 1 should be avoided. Conventionally this is achieved by avoiding placing the back side of the PV module 1 against a thermal insulator, for example, by leaving it open to air circulation. When used in a floating PV array as described above, the lower plate 8 is in direct contact with the mat 2, which again is arranged on the body of water on which the array is floating. As such, the module 1 is cooled by the body of water. Such stable and effective cooling of the PV modules 1 may improve the efficiency of a solar power plant utilising such PV arrays. To further enhance the cooling of the PV module 1, the mat 2 may be arranged such that a small amount of water flows onto and is retained on its surface, or to be floating just slightly below the surface of the water, so that the lower plate 8 is in direct contact with the body of water.

The present invention may utilise a new way of installing a PV module 1 flat onto a pliable mat 2.

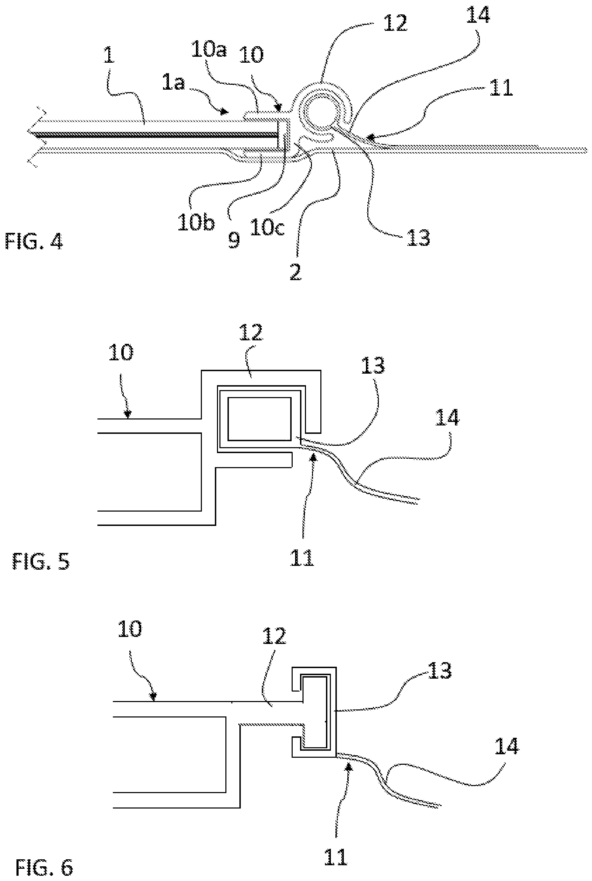

One embodiment of attachment assembly is illustrated in Figure 4. In this case, two elongate profiles 10 are secured to two generally parallel opposite edges 1a of the PV module 1, and are designed to engage with corresponding elongate profiles 11 attached to the mat 2, in order to secure the PV module 1 on the mat 2. The profiles 10, 11 are designed such that the PV module 1 is secured to the mat 2 by bringing the profiles 10 on the PV modules into contact with the corresponding profile 11 on the mat 2, and sliding the profiles relative to one another in a direction generally parallel to the edge 1a of the PV module 1 to which the profile 10 is secured until they reach a desired end position in which separation of the two profiles 10, 11 by the application of a force generally perpendicular to the edge 1a of the PV module 1 is substantially prevented. A fastener may then be applied to prevent any further relative movement of the two profiles generally parallel to the edge 1a of the PV module 1, at which point, the PV module 1 is secured to the mat 2. It will be appreciated that, by virtue of this arrangement, securing the PV modules 1 to the mat 2 is a relatively quick and simple process.

In the event that a PV module 1 needs to be replaced, this process can be reversed to remove the PV module 1 from the mat 2 quickly and easily. Moreover, the PV modules 1 are stackable, and by using such a quick release attachment assembly can easily be deployed or retracted in case of extreme weather.

In this embodiment, the elongate profiles 10 are adhesively bonded to the edges 1a of the PV module, whilst the elongate profiles 11 are welded or sewn to the mat 2.

The profile 10 secured to the PV module 1 may be made from a corrosion resistant metal such as anodised aluminium or stainless steel, whilst the profile secured to the mat 2 may be made from a polymer such as PVC or a composite material.

In this embodiment, the profile 10 attached to the PV module 1 includes a retaining feature 12 which extends generally parallel to the edge 1a of the PV module 1 to which it is attached. In the embodiment illustrated in Figure 4, the retaining feature 12 is connected to the PV module 2 by means of an elongate frame part having two generally parallel legs 10a, 10b connected by a base part 10c. The frame part is inserted over the edge 1a of the PV module 1 so that the edge 1a of the PV module 1 is sandwiched between the two legs 10a, 10b, and the EVA seal is sandwiched between the base 10c and the edge 1a of the PV module 1. The legs 10a, 10b are secured to the lower and upper glass plates 7, 8 by means of a layer of adhesive such as silicon glue. In this embodiment, the frame part is integral with the retaining feature 12.

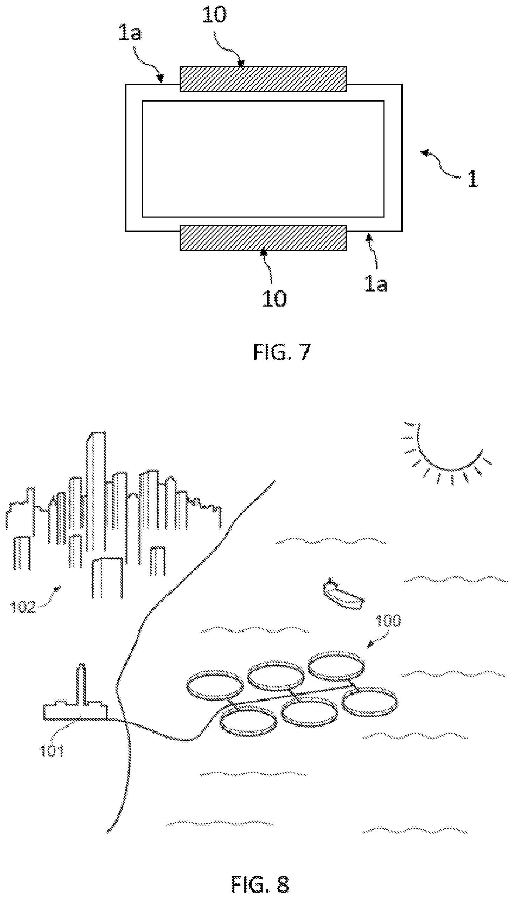

Advantageously, the profile 10 extends along the entire length of the edge 1a of the PV module 1, but this need not be the case. Equally, a plurality of shorter profiles 10 may be mounted on each or some of the edges 1a. A pair, or pairs, of profiles 10 may be fixed to the module 1 at opposite sides 1a of the module 1. This is illustrated schematically in Fig. 7.

In a preferred embodiment, each profile 10 has a length which is at least 40%, at least 50%, at least 60% or at least 70% of the length of the edge 1a. The module 1 may comprise exactly two such profiles 10, arranged at opposite edges 1a. Alternatively, the module 1 may comprise exactly four such profiles 10 arranged at opposite edges 1a, the combined length of two profiles 10 being at least 40%, at least 50%, at least 60% or at least 70% of the length of the edge 1a.

The profile 11 secured to the mat 2 includes a corresponding retaining feature 13 which is secured to the mat 2 using a web 14 which ensures that the separation between the mat 2 and the retaining feature 13 is generally constant along substantially the entire length of the retaining feature 13. One of the retaining features 12 may be a male part which is inserted into a corresponding female part of the other retaining feature 13.

For example, the male part could comprise an elongate tube or rod which is arranged so that its longitudinal axis extends generally parallel to the edge 1a of the PV module 1, whilst the female part comprises an elongate tube having a split which extends parallel to its longitudinal axis. The split may have an opening which is less than a width of the tube or rod.

This is the case in the embodiment illustrated in Figure 4 in which the female part forms part of the profile 10 which is secured to the PV module 1, whilst the male part forms part of the profile 11 which is secured to the mat 2. To secure the PV module 1 to the mat 2, the male part 13 of each profile 11 is inserted into an end of the female part 12 of each corresponding profile 10 with the web 14 extending through the split.

Also in the embodiment illustrated in Figure 4, the male part 13 is a tube with a generally annular transverse cross-section, whilst the female part 12 is a split tube with a generally C-shaped cross-section. It will be appreciated, however, that various configurations of parts, such as those illustrated in Figures 5 and 6, would be equally effective. For example, the male part could be a tube or rod with a square, rectangular or triangular transverse cross-section, and the female part a split tube with a correspondingly shaped transverse cross-section. Alternatively, the male part could have a generally T-shaped transverse cross-section, whilst the female part is a split tube with a generally rectangular cross-section. It should also be appreciated that the male part could equally be secured to the PV module 1 whilst the female part is secured to the mat 2, as in the example illustrated in Figure 6.

As mentioned above, once the female part is lodged in the desired position in the male part, preferably so that it is completely enclosed by the male part, a clip, screw or other fastener is then applied to prevent the female part from sliding out of the male part when the mat is in motion from waves, water current or installation personnel walking on the mat. This process is then repeated with the profiles 10, 11 on the opposite edge 1a of the PV module 1, to completely secure the PV module 1 to the mat 2.

In the embodiments described above, the retaining feature 13 is secured to the mat 2 by a flexible web 14, whilst the other retaining formation . Advantageously, to improve the ease of installation of the PV module 1, there is a small amount of slack in that web 14, so a limited amount of movement between the installed PV module 1 and the mat 2 is permitted when the PV module 1 is installed. It will be appreciated, however, that this could equally be achieved by connecting the retaining feature 12 to the PV module 1 by means of a flexible web, whilst the connection between retaining feature 13 and the mat 2 is rigid.

In an alternative embodiment, a dual glass PV module is equipped with one or several brackets. The bracket can have slits, holes or similar features that can serve as anchoring points for tying, folding or wrapping polymer bands or ropes to the module.

In a further alternative embodiment, the PV module is fastened as is with the aid of features in the mat itself. These can be pockets, velcro straps, zippers or the like that is integrated in the mat surface be thermoplastic welding, adhesive bonding or sewing.

Advantageously, a fixation arrangement according to embodiments described above may provide easier and safer installation and/or retrieval of the PV modules. Additionally, or alternatively, the profiles 10 and their arrangement reduce the structural load on the module 1 when subjected to e.g. wave motion, and may thus allow the use of material combinations and/or thicknesses for the upper and lower plates 7,8 which would otherwise not be possible, for example the use of a glass/glass combination. The profiles 10 can be fitted with rubber lining to avoid direct metallic contact. Overall, embodiments described herein thus reduce the risk of fracturing of the relatively brittle components of the modules 1 as well as other mechanical damage or fatigue.

The solar power plant is installed by deploying each PV array onto a body of water such as the sea, so that it floats at or on the surface of the body of water. This step may be carried out from a vessel or from the shore. Once installed in the desired location, the mat 2 may then be fixed to the seabed via a floating element as described above.

The PV modules may be secured to the mat 2 as described above, or removed from the mat, before the mat 2 is deployed onto the body of water, or when the mat 2 is floating on the surface of the body of water.

Where the PV array is deployed from or retrieved to a vessel, it may be transported on the vessel folded and stacked on board the vessel.

Figure 8 illustrates an embodiment of an offshore photovoltaic power plant 100. The power plant 100 is arranged in a near-shore location near a densely populated area 101, such as a city. The power plant 100 comprises a plurality of PV arrays as described above, which in this embodiment are mounted on circular mats 2. In the embodiment shown in Fig. 8, six units are moored near-shore. The power plant 100 is electrically connected to an onshore power station 101, for distribution of the produced electric power to the city 101 and/or to other onshore consumers via an onshore grid (not shown). An embodiment such as that shown in Figure 8 may therefore, for example, provide significantly more electrical power than what would be available from onshore solar power plants in view of the usually limited land area near densely populated areas.

The PV power plant may also be combined with batteries and preferably be used in combination with low energy density redox flow battery technology.

A PV power plant according to embodiments described herein may advantageously be combined with other offshore renewable power generators, such as wind turbine generators.

Embodiments of the invention can work well in combination with offshore wind parks where access to and from the windmills may be troublesome in rough sea. The presence of several large PV arrays as described above may have a calming effect on the sea in the vicinity of the offshore installations. It may, for example, prevent wind induced breaking of waves, ripples and chopped seas, whilst the individual PV modules 1 will experience slow heave motion when subjected to large swells. Dampening of waves, similar to the effect of oil on troubled waters or wave dampening from e.g. grease ice can have a profound influence on working environment and/or the overall fatigue life of offshore constructions. This improves service life of the wind power generators and reduces inspection and maintenance needs, while also easing access to the wind power generators. Solar PV also works well in combination with wind power due to overlapping power generation weather conditions during e.g. low wind and high solar radiation and vice versa. Furthermore, for such applications, the floating solar PV and offshore windmills may share a power cable infrastructure to land.

The PV power plant according to the embodiments described above could be used to provide electrical power for a fish farm, as described in WO2017/209625, for example. Embodiments according to the present invention thus provide a novel and improved offshore photovoltaic power plant, and associated methods. According to some embodiments, installing such a power plant in harsh offshore environment can be made easier and more secure, at a reduced installation cost.

In some embodiments, the problem of reduced power production caused by heating of the solar cells can be reduced and a low cell operating temperature can be enabled, which increases the energy efficiency. The influence of waves on the installation, operation and structural integrity of the power plant may be lower than for known solutions, thus ensuring reliable and long life operation.

In any of the embodiments above, each module 1 may be substantially stiff by means of the upper plate 7 being a stiff plate, the lower plate 8 being a stiff plate, or both the upper and lower plates being stiff plates. By being substantially stiff, the modules are not compliant to folding or bending.

In any of the embodiments above, the modules may be separate modules which are not interconnected, but fixed only to the mat 2. Each module 1 may thus be spaced from other modules. By being spaced from each other, the modules 1 themselves are not physically linked. This may, for example, reduce the risk of damage to the modules 1 or to the PV cells arranged within the modules.

The modules 1 may, for example, be arranged in an x-y pattern, with rows and columns of modules, each row and each column comprising a plurality of individual modules 1.

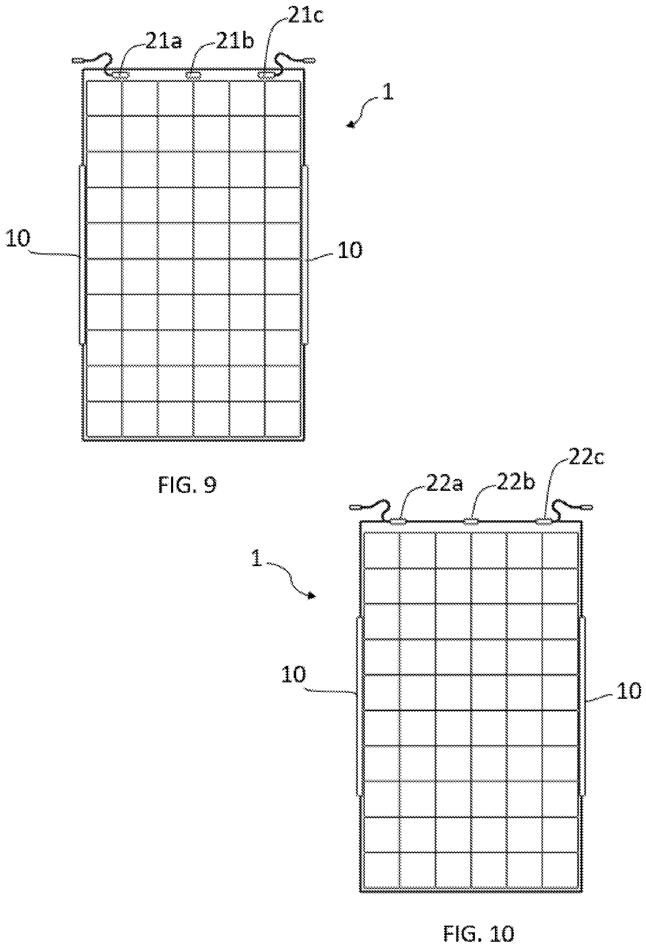

Illustrated in Figs 9 and 10, in any of the embodiments above, each module 1 may comprise one or more junction boxes 21a-c, 22a-c for electric distribution. The junction boxes may be positioned on a top surface, i.e. an upward-facing surface, of the module 1, as shown in Fig. 9 with junction boxes 21a-c. Alternatively, the junction boxes may be positioned on a side surface of the module 1, as shown in Fig. 10 with junction boxes 22a-c. Alternatively, the junction boxes may be positioned on the profiles 10 (this case is not illustrated).

Advantageously, by positioning the junction boxes in one of these configurations, one can achieve an uninterrupted flat surface between the module 1 and the mat 2. The junction boxes 22a-c, 23a-c can preferably be placed on or adjacent the side edges or the front face of the solar panel module 1, as seen in Figs 9 and 10.

## Claims

1. A solar power plant comprising a pliable mat (2) having a plurality of photovoltaic (PV) modules (1) fixed thereon, each PV module (1) being releasably secured to the mat (2) by means of an attachment assembly which comprises at least one elongate module profile (10) secured to an edge of the PV module (1), and a corresponding elongate mat profile (11) attached to the mat (2), and the profiles (10, 11) are configured such that the PV module (1) is releasably secured to the mat (2) by bringing the module profile (10) into contact with the corresponding mat profile (11), and sliding the profiles (10,11) relative to one another in a direction generally parallel to the edge of the PV module (1) to which the module profile (10) is secured, until they reach a desired end position in which separation of the two profiles (10,11) by the application of a force generally perpendicular to the edge of the PV module (1) is substantially prevented.

2. A solar power plant according to claim 1 wherein each PV module (1) is provided with two module profiles (10) secured to two generally parallel opposite edges of the PV module (1), and two corresponding generally parallel mat profiles (11).

3. A solar power plant according to claim 1 or 2 wherein a fastener is provided, which when engaged, prevents any further relative movement of the two profiles (10,11) generally parallel to the edge of the PV module (1).

4. A solar power plant according to any one of claims 1 to 3 wherein each mat profile (11) is welded or sewn to the mat (2).

5. A solar power plant according to any one of claims 1 to 4 wherein the module profile (10) includes an elongate retaining feature (12) which extends generally parallel to the edge of the PV module (1) to which it is attached.

6. A solar power plant according to claim 5 wherein the retaining feature (12) is connected to the PV module (1) by means of an elongate frame part having two generally parallel legs (10a, 10b) connected by a base part (10c).

7. A solar power plant according to any one of claims 1 to 6 wherein each PV module (1) comprises a layer of photovoltaic cells (6) sandwiched between an upper plate (7) , and a lower plate (8).

8. A solar power plant according to claims 6 and 7 wherein the legs (10a, 10b) are secured to the lower and upper plates (7,8) by means of an adhesive.

9. A solar power plant according to claim 6 wherein the frame part is integral with the retaining feature (12).

10. A solar power plant according to any one of claims 1 to 9 wherein the module profile (10) extends along the entire edge of the PV module (10).

11. A solar power plant according to any one of claims 5 to 10 wherein the mat profile (11) includes an elongate retaining feature (13) which is configured to mate with the retaining feature (12) of the module profile (10) and which is secured to the mat using a web, which ensures that the separation between the mat and the retaining feature (13) is generally constant along substantially the entire length of the retaining feature, one of the retaining features (12, 13) has a male part which is inserted into a corresponding female part of the other retaining feature (12, 13), and the male part comprises an elongate tube or rod, whilst the female part comprises an elongate tube having a split which extends parallel to its longitudinal axis.

12. A method of installing a floating photovoltaic power plant according to any one of claims 1 to 11 comprising the steps of releasably securing a plurality of PV modules (1) to the mat (2) by bringing the module profile (10) of each PV module (1) into contact with a corresponding mat profile (11), and sliding the profiles relative to one another in a direction generally parallel to the edge of the PV module (1) to which the module profile (10) is secured until they reach a desired end position in which separation of the two profiles (10, 11) by the application of a force generally perpendicular to the edge of the PV module (1) is substantially prevented.

13. The method of claims 12 wherein one of the module profile (10) or the mat profile (11) has a retaining feature (12, 13) which is a male part, and the other profile (10, 11) has a retaining feature which is a female part, and the method comprises inserting the male part of one profile into an end of the female part of each corresponding profile before sliding the female part relative to the male part generally parallel to the edge of the PV module (1) to which the module profile (10) is secured, until the male part is at least substantially enclosed by the female part.

14. The method of any one of claims 12 or 13 wherein each PV module (1) is provided with two module profiles (10) secured to generally parallel opposite edges of the PV module (1), and the mat (2) is provided with two corresponding generally parallel mat profiles (11), and the method comprises securing each PV module (1) to the mat by simultaneously, concurrently or sequentially, bringing both the module profiles (10) into contact with their corresponding mat profile (11), and sliding the profiles (10, 11) relative to one another in a direction generally parallel to the edge of the PV module (1) to which each module profile (10) is secured until they reach a desired end position in which separation of the profiles (10, 11) by the application of a force generally perpendicular to the edge of the PV module (1) is substantially prevented.

15. The method of any one of claims 12 to 14 further comprising the step of deploying the mat (2) onto a body of water before carrying out the step of securing the PV module (1) to the mat (2).

## Patentansprüche

1. Solaranlage, umfassend eine nachgiebige Matte (2), die eine Vielzahl von daran befestigten Photovoltaik-(PV-)Modulen (1) aufweist, wobei jedes PV-Modul (1) mittels einer Anbringungsbaugruppe, die zumindest ein längliches Modulprofil (10), das an einer Kante des PV-Moduls (1) gesichert ist, und ein entsprechendes längliches Mattenprofil (11) umfasst, das an der Matte (2) angebracht ist, lösbar an der Matte (2) gesichert ist und wobei die Profile (10, 11) derart konfiguriert sind, dass das PV-Modul (1) lösbar an der Matte (2) gesichert wird, indem das Modulprofil (10) in Kontakt mit dem entsprechenden Mattenprofil (11) gebracht wird und die Profile (10, 11) relativ zueinander in einer Richtung, die im Allgemeinen parallel zu der Kante des PV-Moduls (1) ist, an der das Modulprofil (10) gesichert ist, verschoben werden, bis sie eine gewünschte Endposition erreichen, in der eine Trennung der zwei Profile (10, 11) durch die Anwendung einer Kraft, die im Allgemeinen senkrecht zu der Kante des PV-Moduls (1) ist, im Wesentlichen verhindert wird.

2. Solaranlage nach Anspruch 1, wobei jedes PV-Modul (1) mit zwei Modulprofilen (10), die an zwei im Allgemeinen parallelen gegenüberliegenden Kanten des PV-Moduls (1) gesichert sind, und zwei entsprechenden im Allgemeinen parallelen Mattenprofilen (11) bereitgestellt ist.

3. Solaranlage nach Anspruch 1 oder 2, wobei ein Befestigungselement bereitgestellt ist, das im Eingriff jede weitere relative Bewegung der zwei Profile (10, 11) im Allgemeinen parallel zu der Kante des PV-Moduls (1) verhindert.

4. Solaranlage nach einem der Ansprüche 1 bis 3, wobei jedes Mattenprofil (11) an die Matte (2) geschweißt oder genäht ist.

5. Solaranlage nach einem der Ansprüche 1 bis 4, wobei das Modulprofil (10) ein längliches Rückhaltemerkmal (12) beinhaltet, das sich im Allgemeinen parallel zu der Kante des PV-Moduls (1) erstreckt, an der es angebracht ist.

6. Solaranlage nach Anspruch 5, wobei das Rückhaltemerkmal (12) mit dem PV-Modul (1) mittels eines länglichen Rahmenteils verbunden ist, das zwei im Allgemeinen parallele Schenkel (10a, 10b) aufweist, die durch ein Basisteil (10c) verbunden sind.

7. Solaranlage nach einem der Ansprüche 1 bis 6, wobei jedes PV-Modul (1) eine Schicht von Photovoltaik-Zellen (6) umfasst, die zwischen einer oberen Platte (7) und einer unteren Platte (8) eingeklemmt ist.

8. Solaranlage nach Anspruch 6 und 7, wobei die Schenkel (10a, 10b) an der unteren und der oberen Platte (7, 8) mittels eines Klebstoffs gesichert sind.

9. Solaranlage nach Anspruch 6, wobei das Rahmenteil einstückig mit dem Rückhaltemerkmal (12) ist.

10. Solaranlage nach einem der Ansprüche 1 bis 9, wobei sich das Modulprofil (10) entlang der gesamten Kante des PV-Moduls (10) erstreckt.

11. Solaranlage nach einem der Ansprüche 5 bis 10, wobei das Mattenprofil (11) ein längliches Rückhaltemerkmal (13) beinhaltet, das dazu konfiguriert ist, mit dem Rückhaltemerkmal (12) des Modulprofils (10) zusammenzupassen, und das an der Matte unter Verwendung eines Gewebes gesichert ist, das sicherstellt, dass die Trennung zwischen der Matte und dem Rückhaltemerkmal (13) im Allgemeinen im Wesentlichen entlang der gesamten Länge des Rückhaltermerkmals konstant ist, eines der Rückhaltemerkmale (12, 13) ein Steckteil aufweist, das in ein entsprechendes Aufnahmeteil des anderen Rückhaltemerkmals (12, 13) eingeführt wird, und das Steckteil ein längliches Rohr oder eine längliche Stange umfasst, während das Aufnahmeteil ein längliches Rohr umfasst, das eine Teilung aufweist, die sich parallel zu seiner Längsachse erstreckt.

12. Verfahren zum Installieren einer schwimmenden Photovoltaik-Anlage nach einem der Ansprüche 1 bis 11, umfassend die Schritte des lösbaren Sicherns einer Vielzahl von PV-Modulen (1) an der Matte (2), indem das Modulprofil (10) jedes PV-Moduls (1) in Kontakt mit einem entsprechenden Mattenprofil (11) gebracht wird und die Profile relativ zueinander in einer Richtung, die im Allgemeinen parallel zu der Kante des PV-Moduls (1) ist, an der das Modulprofil (10) gesichert ist, verschoben werden, bis sie eine gewünschte Endposition erreichen, in der eine Trennung der zwei Profile (10, 11) durch die Anwendung einer Kraft, die im Allgemeinen senkrecht zu der Kante des PV-Moduls (1) ist, im Wesentlichen verhindert wird.

13. Verfahren nach Anspruch 12, wobei eines von dem Modulprofil (10) oder dem Mattenprofil (11) ein Rückhaltemerkmal (12, 13) aufweist, das ein Steckteil ist, und das andere Profil (10, 11) ein Rückhaltemerkmal aufweist, das ein Aufnahmeteil ist, und das Verfahren Einführen des Steckteils eines Profils in ein Ende des Aufnahmeteils jedes entsprechenden Profils umfasst, bevor das Aufnahmeteil relativ zu dem Steckteil im Allgemeinen parallel zu der Kante des PV-Moduls (1), an der das Modulprofil (10) gesichert ist, verschoben wird, bis das Steckteil zumindest im Wesentlichen von dem Aufnahmeteil umschlossen ist.

14. Verfahren nach einem der Ansprüche 12 oder 13, wobei jedes PV-Modul (1) mit zwei Modulprofilen (10), die an im Allgemeinen parallelen gegenüberliegenden Kanten des PV-Moduls (1) gesichert sind, bereitgestellt ist und die Matte (2) mit zwei entsprechenden im Allgemeinen parallelen Mattenprofilen (11) bereitgestellt ist und das Verfahren Sichern jedes PV-Moduls (1) an der Matte durch simultanes, gleichzeitiges oder sequentielles Inkontaktbringen beider Modulprofile (10) mit ihrem entsprechenden Mattenprofil (11) und Verschieben der Profile (10, 11) relativ zueinander in einer Richtung, die im Allgemeinen parallel zu der Kante des PV-Moduls (1) ist, an der jedes Modulprofil (10) gesichert ist, bis sie eine gewünschte Endposition erreichen, in der eine Trennung der Profile (10, 11) durch die Anwendung einer Kraft, die im Allgemeinen senkrecht zu der Kante des PV-Moduls (1) ist, im Wesentlichen verhindert wird, umfasst.

15. Verfahren nach einem der Ansprüche 12 bis 14, ferner umfassend den Schritt des Einsetzens der Matte (2) auf ein Gewässer vor dem Ausführen des Schritts des Sicherns des PV-Moduls (1) an der Matte (2).

## Revendications

1. Centrale solaire comprenant un tapis (2) pliable sur lequel sont fixés une pluralité de modules photovoltaïques (PV) (1), chaque module PV (1) étant fixé de manière libérable au tapis (2) au moyen d'un ensemble d'attachequi comprend au moins un profil de module allongé (10) fixé à un bord du module PV (1), et un profil de tapis allongé (11) correspondant attaché au tapis (2), et les profils (10, 11) sont configurés de sorte que le module PV (1) est fixé de manière libérable au tapis (2) en amenant le profil de module (10) en contact avec le profil de tapis (11) correspondant et en faisant coulisser les profils (10, 11) l'un par rapport à l'autre dans une direction généralement parallèle au bord du module PV (1) auquel le profil de module (10) est fixé, jusqu'à ce qu'ils atteignent une position finale souhaitée dans laquelle la séparation des deux profils (10, 11) par l'application d'une force généralement perpendiculaire au bord du module PV (1) est sensiblement empêchée.

2. Centrale solaire selon la revendication 1, dans laquelle chaque module PV (1) est pourvu de deux profils de module (10) fixés à deux bords opposés généralement parallèles du module PV (1), et de deux profils de tapis (11) généralement parallèles correspondants.

3. Centrale solaire selon la revendication 1 ou 2, dans laquelle est prévue une attache qui, lorsqu'elle est mise en prise, empêche tout autre mouvement relatif des deux profils (10, 11) généralement parallèlement au bord du module PV (1).

4. Centrale solaire selon l'une quelconque des revendications 1 à 3, dans laquelle chaque profil de tapis (11) est soudé ou cousu au tapis (2).

5. Centrale solaire selon l'une quelconque des revendications 1 à 4, dans laquelle le profil de module (10) comporte un élément de retenue allongé (12) qui s'étend généralement parallèlement au bord du module PV (1) auquel il est attaché.

6. Centrale solaire selon la revendication 5, dans laquelle l'élément de retenue (12) est relié au module PV (1) au moyen d'une partie de cadre allongée ayant deux pattes (10a, 10b) généralement parallèles reliées par une partie de base (10c).

7. Centrale solaire selon l'une quelconque des revendications 1 à 6, dans laquelle chaque module PV (1) comprend une couche de cellules photovoltaïques (6) prise en sandwich entre une plaque supérieure (7) et une plaque inférieure (8).

8. Centrale solaire selon les revendications 6 et 7, dans laquelle les pattes (10a, 10b) sont fixées aux plaques inférieure et supérieure (7, 8) au moyen d'un adhésif.

9. Centrale solaire selon la revendication 6, dans laquelle la partie de cadre fait partie intégrante de l'élément de retenue (12) .

10. Centrale solaire selon l'une quelconque des revendications 1 à 9, dans laquelle le profil de module (10) s'étend le long de tout le bord du module PV (10).

11. Centrale solaire selon l'une quelconque des revendications 5 à 10, dans laquelle le profil de tapis (10) comporte un élément de retenue allongé (13) qui est configuré pour s'accoupler avec l'élément de retenue (12) du profil de module (10) et qui est fixé au tapis à l'aide d'une bande, ce qui garantit que la séparation entre le tapis et l'élément de retenue (13) est généralement constante le long de sensiblement toute la longueur de l'élément de retenue, l'un des éléments de retenue (12, 13) a une partie mâle qui est insérée dans une partie femelle correspondante de l'autre élément de retenue (12, 13), et la partie mâle comprend un tube ou une tige allongé(e), tandis que la partie femelle comprend un tube allongé ayant une fente qui s'étend parallèlement à son axe longitudinal.

12. Procédé d'installation d'une centrale photovoltaïque flottante selon l'une quelconque des revendications 1 à 11 comprenant les étapes 'de fixation libérable d'une pluralité de modules PV (1) au tapis (2) en amenant le profil de module (10) de chaque module PV (1) en contact avec un profil de tapis (11) correspondant, et en faisant coulisser les profils les uns par rapport aux autres dans une direction généralement parallèle au bord du module PV (1) auquel le profil de module (10) est fixé jusqu'à ce qu'ils atteignent une position finale souhaitée dans laquelle la séparation des deux profils (10, 11) par l'application d'une force généralement perpendiculaire au bord du module PV (1) est sensiblement empêchée.

13. Procédé selon la revendication 12, dans lequel l'un parmi le profil de module (10) ou le profil de tapis (11) a un élément de retenue (12, 13) qui est une partie mâle, et l'autre profil (10, 11) a un élément de retenue qui est une partie femelle, et le procédé comprend l'insertion de la partie mâle d'un profil dans une extrémité de la partie femelle de chaque profil correspondant avant de faire coulisser la partie femelle par rapport à la partie mâle généralement parallèlement au bord du module PV (1) auquel le profil de module (10) est fixé, jusqu'à ce que la partie mâle soit au moins sensiblement entourée par la partie femelle.

14. Procédé selon l'une quelconque des revendications 12 ou 13, dans lequel chaque module PV (1) est pourvu de deux profils de module (10) fixés à des bords opposés généralement parallèles du module PV (1), et le tapis (2) est pourvu de deux profils de tapis (11) généralement parallèles correspondants, et le procédé comprend 'la fixation de chaque module PV (1) au tapis en amenant simultanément, en même temps ou séquentiellement les deux profils de module (10) en contact avec leur profil de tapis (11) correspondant, et en faisant coulisser les profils (10, 11) l'un par rapport à l'autre dans une direction généralement parallèle au bord du module PV (1) auquel chaque profil de module (10) est fixé jusqu'à ce qu'ils atteignent une position finale souhaitée dans laquelle la séparation des profils (10, 11) par l'application d'une force généralement perpendiculaire au bord du module PV (1) est sensiblement empêchée.

15. Procédé selon l'une quelconque des revendications 12 à 14, comprenant en outre l'étape de déploiement du tapis (2) sur un plan d'eau avant d'effectuer l'étape 'de fixation du module PV (1) au tapis (2).
